# EUROPÄISCHE PATENTSCHRIFT

(11) **EP 0 800 756 B1**
(45) Veröffentlichungstag und Bekanntmachung des Hinweises auf die Patenterteilung: **02.09.1998**
(21) Anmeldenummer: 95942636.2
(22) Anmeldetag: 19.12.1995
(51) Int. Cl.: H05K 13/08, G01R 31/311, G01N 21/88

(54) **VORRICHTUNG ZUR LAGEERKENNUNG DER ANSCHLÜSSE VON BAUELEMENTEN**
DEVICE FOR DETERMINING THE POSITION OF CONNECTIONS OF COMPONENTS
DISPOSITIF DE RECONNAISSANCE DE LA POSITION DES CONNEXIONS DE COMPOSANTS

(30) Priorität: 30.12.1994 DE 4447242
(43) Veröffentlichungstag der Anmeldung: 15.10.1997
(73) Patentinhaber: SIEMENS AKTIENGESELLSCHAFT, 80333 München (DE)
(72) Erfinder: GRASMÜLLER, Hans, Horst, D-82291 Mammendorf (DE); WITTMANN, Günther, D-80796 München (DE)
(86) Internationale Anmeldenummer: DE9501819
(87) Internationale Veröffentlichungsnummer: WO9621343

(56) Entgegenhaltungen:
- EP-A- 0 341 806
- IBM TECHNICAL DISCLOSURE BULLETIN, Bd. 32, Nr. 8b, Januar 1990, NEW YORK US, Seiten 11-12, XP000082202 "lighting method for automatic solder bond inspection"

## Beschreibung

Bei der automatischen Bestückung von Substraten, insbesondere von Leiterplatten oder Keramiksubstraten, mit SMD-Bauelementen für die Oberflächenmontage (SMD = Surface Mounted Devices), ist die Visiontechnik von entscheidender Bedeutung für das Erzielen einer hohen Bestückgenauigkeit. Die Visiontechnik umfaßt dabei ein Substrat-Visionsystem und ein Bauelemente-Visionsystem. Das Substrat-Visionsystem erfaßt mittels einer CCD-Kamera Referenzmarken oder Schaltungsstrukturen der Substrate. Aus der Lage der Referenzmarken ermittelt ein Rechner die genaue Position des Substrats (X, Y, ϕ) und einen eventuell vorhandenen Verzug. Zur Bestückung werden alle Bestückpositionen (X, Y, ϕ) entsprechend korrigiert.

Das Bauelemente-Visionsystem besteht aus CCD-Kamera, Beleuchtung und Mattscheibe. Das entsprechende Bauelemente-Visionmodul wird auf den Bereitstelltisch der Zuführmodule gesetzt. Der Bestückkopf setzt die Bauelemente so auf die Mattscheibe, daß deren Anschlüsse erkannt werden können. Die Lageabweichung der Anschlüsse wird beispielsweise mit einem gespeicherten Muster durch optoelektronische Korrelation aller Anschlüsse ermittelt. Mit den Werten der Lageabweichungen korrigiert der Bestückautomat die Bestückwege und den Drehwinkel zu der vorher mit einem Substrat-Visionsystem ermittelten genauen Bestückposition (X, Y, ϕ).

Die vorstehend geschilderte optoelektronische Zentrierung von Bauelementen mit Hilfe eines Bauelemente-Visionsystems bereitet bei einigen Arten von Bauelementen, insbesondere bei Flip-Chips, Bare-Chips und Ball-Grid-Arrays erhebliche Schwierigkeiten. Betrachtet man die Anschlüsse deren Lage erkannt werden soll als Nutzstrukturen und alle anderen optisch hervortretenden Strukturen der Bauelemente als Störstrukturen, so sind die Schwierigkeiten der optoelektronischen Zentrierung der Bauelemente darauf zurückzuführen, daß neben den Nutzstrukturen auch die Störstrukturen zumindest teilweise deutlich abgebildet werden. Hierdurch wird eine zuverlässige Bildauswertung erschwert oder gänzlich verhindert. Als Störstrukturen sind beispielsweise bei Flip-Chips die Aluminiumleiterbahnen, die Silizium-Nitrid-Strukturen und die Silizium-Oxid-Strukturen zu nennen. Auch die Körper und Kanten der Bauelemente sind als Störstrukturen zu betrachten.

Durch die EP, A, 0 341 806 ist eine Einrichtung zur Inspektion von Leiterplatten mit SMD-Bausteinen bekannt geworden, die über der Leiterplatte verfahrbar ist. Die Einrichtung enthält einen zylindrischen Schacht, in dem zwei übereinanderliegende Ringlicht-Beleuchtungen sowie vier Kameras angeordnet sind. Die Ringlichtbeleuchtungen sind in je 4 Segmente unterteilt, deren Mittelbereiche vom Zentrum aus in den Hauptkoordinatenrichtungen der Leiterplatte liegen. Die Kameras sind ebenfalls konzentrisch von außen her schräg auf die Leiterplatte gerichtet. Ihre Mittelachsen decken sich mit den Koordinatenrichtungen.

Die Einrichtung dient dazu, die Anwesenheit und Lage der auf der Leiterplatte angelöteten Bauelemente zu überprüfen. Dabei wird die Einrichtung insbesondere auf die Seitenkanten des Bauelements derart gerichtet, daß jeweils das in diese Richtung weisende Ringlichtsegment und die diesem zugeordnete Kamera aktiviert werden. Die Einrichtung dient ebenfalls dazu, die Lage von Lötstellen auf der Leiterplatte zu ermitteln. Dies geschieht durch Aktivieren zweier der Lötstelle gegenüberliegender Segmente und einer zu diesen senkrecht gerichteten Kamera.

Der im Anspruch 1 angegebenen Erfindung liegt das Problem zugrunde, eine Vorrichtung zur Lageerkennung der Anschlüsse von Bauelementen zu schaffen, bei welcher die zu erkennenden Anschlüsse optisch isoliert und störende Strukturdetails zur Vereinfachung der Bildauswertung optisch unterdrückt werden.

Der Erfindung liegt die Erkenntnis zugrunde, daß bei Flip-Chips, Bare-Chips, Ball-Grid-Arrays und vergleichbaren Bauelementen mit kugelförmigen Anschlüssen die optischen Störstrukturen in zwei Hauptrichtungen verlaufen, wobei diese Hauptrichtungen in der Regel mit den Richtungen der Bauelementekanten übereinstimmen. Werden nun bei der Beleuchtung die parallel und senkrecht zu den Störstrukturen einfallenden Lichtrichtungen unterdrückt, so werden die in ihrer Lage zu erkennenden Anschlüsse deutlich kontrastreicher als die Störstrukturen dargestellt.

Vorteilhafte Ausgestaltungen der Erfindung sind in den Unteransprüchen angegeben.

Die Ausgestaltung nach Anspruch 2 begrenzt die ausgeschlossenen Winkelsegmente der Ringlicht-Beleuchtung auf ± 15°, so daß auch bei größeren Zuführtoleranzen der Bauelemente die Störstrukturen deutlich schwächer als die Nutzstrukturen abgebildet werden. Optimale Bedingungen im Hinblick auf eine möglichst intensive Beleuchtung der Nutzstrukturen ergeben sich gemäß Anspruch 3 wenn die ausgeschlossenen Winkelsegmente ungefähr ± 10° betragen.

Bei Bauelementen mit stark ausgeprägten Störstrukturen ist gemäß Anspruch 4 eine segmentierte Ringlicht-Beleuchtung besonders geeignet, deren Strahlen allseitig unter einem Beleuchtungswinkel von 45° bis 90° zur optischen Achse des Objektivs auf die Oberfläche der Bauelemente fallen. Noch besser für die Abbildung der kugelförmigen Anschlüsse von Bauelementen mit stark ausgeprägten Störstrukturen sind gemäß Anspruch 5 Beleuchtungswinkel von 55° bis 65°, während sich gemäß Anspruch 6 bei einem Beleuchtungswinkel von ungefähr 60° optimale Bedingungen für die Abbildung und Lageerkennung der Anschlüsse ergeben.

Die Ausgestaltung nach Anspruch 7 ermöglicht eine einfache und wirtschaftliche Realisierung einer Ringlicht-Beleuchtung unter flachem Winkel.

Die Ausgestaltung nach Anspruch 8 ermöglicnt durch eine segmentierte Ringlicht-Beleuchtung mit Beleuchtungswinkeln von 15° bis 45° eine intensitätsstarke Beleuchtung der Anschlüsse von Bauelementen mit schwach ausgeprägten Störstrukturen. Noch besser sind in diesem Fall gemäß Anspruch 9 Beleuchtungswinkel von 25° bis 35°, während sich gemäß Anspruch 10 bei einem Beleuchtungswinkel von ungefähr 30° optimale Bedingungen für eine intensitätsstarke Abbildung der Anschlüsse von Bauelementen mit schwach ausgeprägten Störstrukturen ergeben.

Die Ausgestaltung nach Anspruch 11 ermöglicht eine einfache und wirtschaftliche Realisierung einer Ringlicht-Beleuchtung unter mittelsteilem Winkel.

Ausführungsbeispiele der Erfindung sind in der Zeichnung dargestellt und werden im folgenden näher beschrieben. Es zeigen
- Figur 1: ein Bauelement mit kugelförmigen Anschlüssen und in zwei Hauptrichtungen verlaufenden optischen Störstrukturen in der Draufsicht,
- Figur 2: das Prinzip einer segmentierten Ringlicht-Beleuchtung für das in Figur 1 dargestellte Bauelement,
- Figur 3: eine erste Variante des in Figur 2 dargestellten Prinzips,
- Figur 4: eine zweite Variante des in Figur 2 dargestellten Prinzips und
- Figur 5: eine Vorrichtung zur Lageerkennung der Anschlüsse von Bauelementen im Längsschnitt.

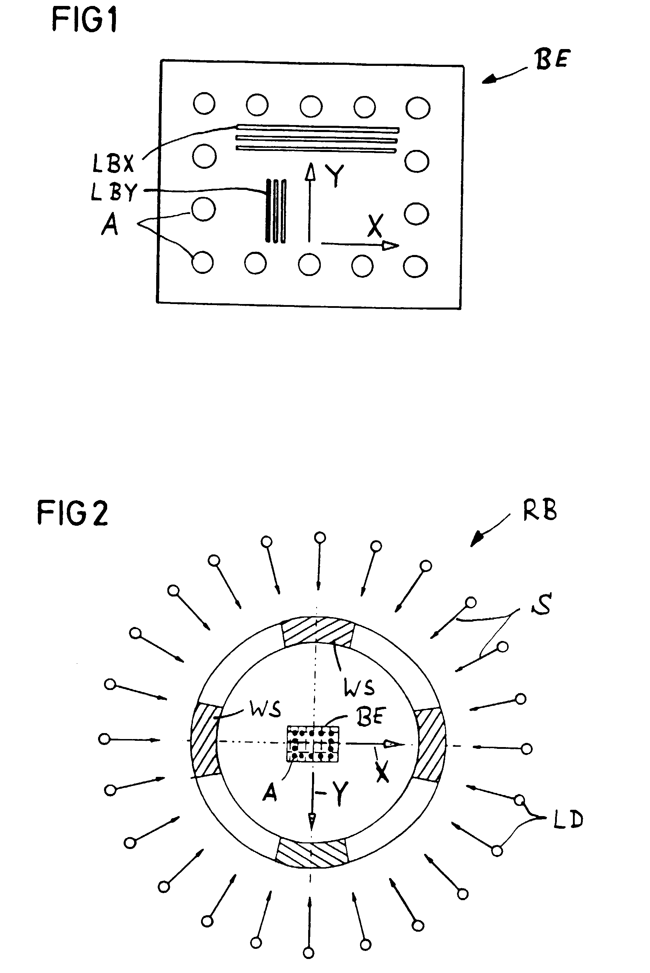

Figur 1 zeigt in stark vereinfachter schematischer Darstellung eine Draufsicht auf ein Bauelement BE, dessen im Randbereich angeordnete, kugelförmige Anschlüsse mit A bezeichnet sind. Außerdem sind durch Pfeile zwei zueinander senkrechte und parallel zu den Bauelementekanten verlaufende Hauptrichtungen X und Y angegeben. Ferner sind in Figur 1 in X-Richtung verlaufende Leiterbahnen LBX und in Y-Richtung verlaufende Leiterbahnen LBY angedeutet, die jeweils aus Aluminium bestehen. Diese Aluminiumleiterbahnen LBX und LBY werden bei einer konventionellen Beleuchtung der Oberfläche des Bauelements BE deutlich hervorgehoben, d.h. sie stören eine Lageerkennung der Anschlüsse A und sind somit als optische Störstrukturen zu betrachten. Auch bei den Kanten des Bauelements BE handelt es sich um optische Störstrukturen. Der Körper des Bauelements BE ist ebenfalls als Störstruktur zu betrachten, da seine Größe variieren kann.

Figur 2 zeigt das Grundprinzip einer segmentierten Ringlicht-Beleuchtung, mit welcher die Anschlüsse A des Bauelements BE optisch isoliert und die optischen Störstrukturen zumindest weitgehend unterdrückt werden können. Die mit RB bezeichnete Ringlicht-Beleuchtung umfaßt eine Vielzahl von auf einem Kreis oder einem Polygon angeordneten Leuchtdioden LD, deren Strahlen S ohne zusätzliche Maßnahmen allseitig schräg auf die Oberfläche des im Zentrum angeordneten Bauelements BE einfallen würden. Es ist jedoch zu erkennen, daß die Strahlen S der Ringlicht-Beleuchtung RB im Bereich von Winkelsegmenten WS um die Hauptrichtungen X und Y unterdrückt werden. Zuführtoleranzen der Bauelemente BE werden dadurch berücksichtigt, daß nicht nur die Hauptrichtungen X und Y selbst, sondern Bereiche von ± 10° um die Hauptrichtungen X und Y von der Beleuchtung ausgeschlossen werden.

Die Winkelsegmente WS bewirken, daß die parallel und senkrecht zu den optischen Störstrukturen einfallenden Lichtrichtungen der Ringlicht-Beleuchtung RB unterdrückt werden und daß dadurch die für eine optoelektronische Zentrierung der Bauelemente BE wichtigen Anschlüsse A deutlich kontrastreicher als die optischen Störstrukturen dargestellt werden.

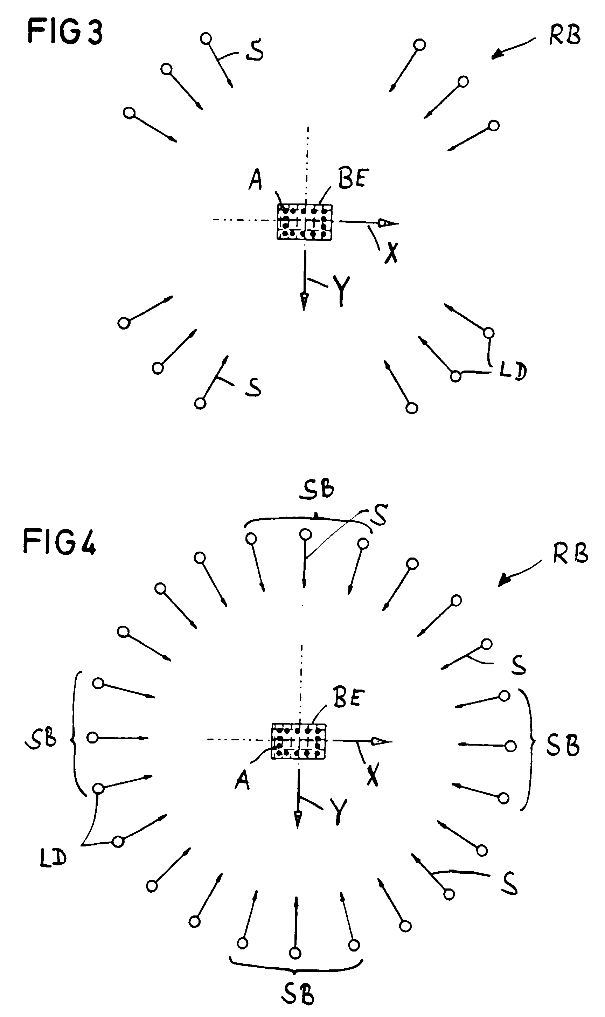

Bei dem in Figur 2 dargestellten Prinzip wird ein Einfall der Strahlen S der Ringlicht-Beleuchtung RB auf die Oberfläche des Bauelements BE im Bereich der Hauptrichtungen X und Y durch die abschattende Wirkung der Winkelsegmente WS unterdrückt. Die gleiche Wirkung kann gemäß Figur 3 auch dadurch erzielt werden, daß die Leuchtdioden LD in den den Winkelsegmenten WS entsprechenden Segmenten der Ringlicht-Beleuchtung RB entfallen.

Gemäß Figur 4 kann die zur Unterdrückung von Störstrukturen erwünschte Wirkung der Ringlicht-Beleuchtung RB auch dadurch erzielt werden, daß die Leuchtdioden LD in den den Winkelsegmenten WS entsprechenden Segmentbereichen SB nicht eingeschaltet werden. Diese Anordnung hat den Vorteil, daß bei Bauelementen BE mit weniger stark ausgeprägten Störstrukturen die Leuchtdioden LD in den Segmentbereichen SB zur Intensitätssteigerung zugeschaltet werden können.

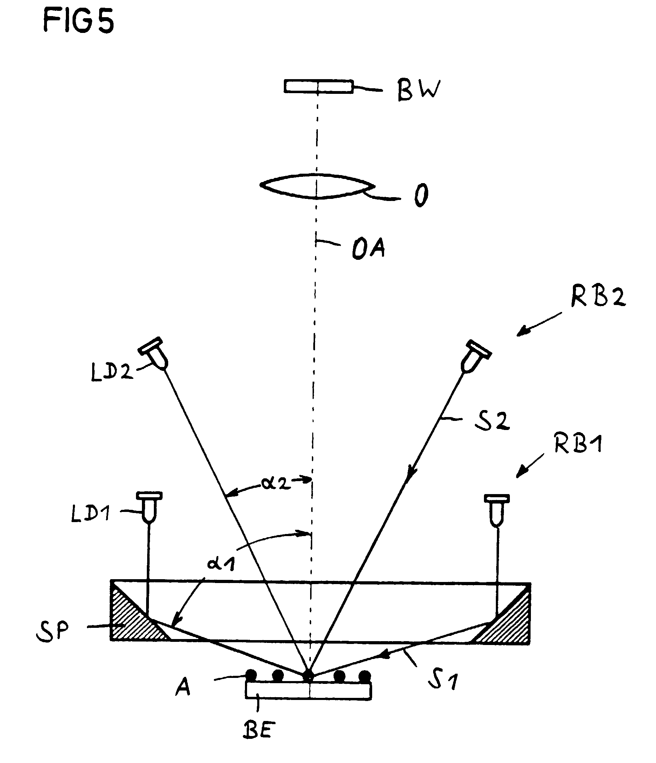

Figur 5 zeigt in stark vereinfachter schematischer Darstellung eine Vorrichtung zur Lageerkennung der Anschlüsse A von Bauelementen BE im Längsschnitt. Die Bauelemente BE werden dabei beispielsweise mit der in Figur 5 nicht näher dargestellten Saugpipette eines Bestückkopfes in die zur Lageerkennung der Anschlüsse A erforderliche Position gebracht. In dieser Position sind die Bauelemente BE zentrisch zur optischen Achse OA eines Objekivs O ausgerichtet, welches die Anschlüsse A auf die lichtempfindliche Fläche eines Bildwandlers BW abbildet. Bei dem Bildwandler BW handelt es sich beispielsweise um eine CCD-Kamera Typ Sony XC75C mit 484 effektiven Zeilen und 746 effektiven Spalten.

Zur Beleuchtung der Oberfläche eines Bauelements BE sind eine erste Ringlicht-Beleuchtung RB1 und eine zweite Ringlicht-Beleuchtung RB2 vorgesehen, die beide separat zu- und abschaltbar sind.

Die erste Ringlicht-Beleuchtung RB1 umfaßt eine Vielzahl von Leuchtdioden LD1, die nach dem in Figur 4 dargestellten Prinzip auf einem zur optischen Achse OA konzentrischen Kreis angeordnet sind. Die von den Leuchtdioden LD1 ausgehenden Strahlen S1 werden über einen koaxial zur optischen Achse OA ausgerichteten Ringspiegel SP auf die Oberfläche des Bauelementes BE gelenkt, wobei der zur optischen Achse OA hin gemessene Beleuchtungswinkel α1 = 60° ist.

Die erste Ringlicht-Beleuchtung RB1 wird zur Beleuchtung von Bauelementen BE mit stark ausgeprägten Störstrukturen eingesetzt, wobei nach dem in Figur 4 dargestellten Muster Segmentbereiche SB von ± 10° um die Hauptrichtungen X und Y nicht eingeschaltet werden. Diese Segmentbereiche SB können jedoch bei Bauelementen BE mit weniger stark ausgeprägten Störstrukturen zur Intensitätssteigerung als Zusatzbeleuchtung eingeschaltet werden.

Die zweite Ringlicht-Beleuchtung RB2 umfaßt eine Vielzahl von Leuchtdioden LD2, die nach dem in Figur 3 dargestellten Prinzip auf einem zur optischen Achse OA konzentrischen Kreis angeordnet sind. Die von den Leuchtdioden LD2 ausgehenden Strahlen S2 sind direkt auf die Oberfläche des Bauelements BE gerichtet, wobei der zur optischen Achse OA hin gemessene Beleuchtungswinkel α2 = 30° ist.

Die zweite Ringlicht-Beleuchtung RB2 wird zur intensitätsstarken Beleuchtung von Bauelementen BE mit schwachen Störstrukturen eingesetzt, wobei nach dem in Figur 3 dargestellten Muster Winkelsegmente um die Hauptrichtungen X und Y von ± 14° zur Unterdrückung von Störstrukturen von der Beleuchtung ausgeschlossen werden.

Für die erste Ringlicht-Beleuchtung RB1 und die zweite Ringlicht-Beleuchtung RB2 werden beispielsweise Leuchtdioden HLMP8103 Typ T eingesetzt, die rotes Licht mit einer Wellenlänge von 637 nm emittieren.

Die in Figur 5 dargestellte Vorrichtung wird in Bestückautomaten für Bauelemente-Visionsysteme eingesetzt. Sie ist insbesondere für die zuverlässige Lageerkennung der kugelförmigen Anschlüsse von Bauelementen geeignet.

## Patentansprüche

1. Vorrichtung zur Lageerkennung der Anschlüsse (A) von Bauelementen (BE), die auf ihrer Anschlußseite zusätzlich zu den Anschlüssen (A) linienhafte, optisch störende Oberflächenstrukturen (z.B. LBX, LBY) aufweisen, die in zwei zueinander senkrecht stehenden Hauptrichtungen (X,Y) parallel zu den Seitenkanten des Bauelements (BE) verlaufen,
wobei die Bauelemente im Wirkbereich der Vorrichtung plazierbar sind,
wobei die Vorrichtung mit einem ein Objektiv (O) aufweisenden Bildwandler (BW)und mindestens einer segmentierten Ringlicht-Beleuchtung (RB; RB1, RB2) versehen ist,
wobei die optische Achse des Objektivs zumindest annähernd durch das Zentrum der Ringlichtbeleuchtung verläuft,
wobei das Objektiv (O) und die Ringlicht-Beleuchtung (RB; RB1, RB2) oberhalb des für die Bauelemente vorgesehenen Platzes angeordnet sind und
wobei das Bauelement (BE) relativ zur Ringlicht-Beleuchtung (RB; RB1, RB2) zumindest annähernd zentral in einer Winkellage plazierbar ist, in der die Strahlen (S;S1,S2) der Ringlicht-Beleuchtung (RB; RB1, RB2) unter Ausschluß von im Bereich der Hauptrichtungen (X,Y) liegenden Winkelsegmenten (WS) allseitig schräg auf die Oberfläche der Bauelemente (BE) gerichtet sind.

2. Vorrichtung nach Anspruch 1,
**dadurch gekennzeichnet**,
daß die ausgeschlossenen Winkelsegmente (WS) der Ringlicht-Beleuchtung (RB;RB1,RB2) im - 15° bis + 15° von den Hauptrichtungen (X,Y) abweichenden Winkelbereich liegen.

3. Vorrichtung nach Anspruch 1,
**dadurch gekennzeichnet**,
daß die ausgeschlossenen Winkelsegmente (WS) der Ringlicht-Beleuchtung (RB1) im ungefähr ± 10° von den Hauptrichtungen (X,Y) abweichenden Winkelbereich liegen.

4. Vorrichtung nach einem der Ansprüche 1 bis 3,
**dadurch gekennzeichnet**,
daß die Strahlen (S1) der segmentierten Richtlicht-Beleuchtung (RB1) unter einem Beleuchtungswinkel (α1) von 45 bis 90° zur optischen Achse (OA) des Objektivs (O) auf die Oberfläche der Bauelemente (BE) gerichtet sind.

5. Vorrichtung nach einem der Ansprüche 1 bis 3,
**dadurch gekennzeichnet**,
daß die Strahlen (S1) der segmentierten Richtlicht-Beleuchtung (RB1) unter einem Beleuchtungswinkel (α1) von 55 bis 65° zur optischen Achse (OA) des Objektivs (O) auf die Oberfläche der Bauelemente (BE) gerichtet sind.

6. Vorrichtung nach einem der Ansprüche 1 bis 3,
**dadurch gekennzeichnet**,
daß die Strahlen (S1) der segmentierten Richtlicht-Beleuchtung (RB1) unter einem Beleuchtungswinkel (α1) von ungefähr 60° zur optischen Achse (OA) des Objektivs (O) auf die Oberfläche der Bauelemente (BE) gerichtet sind.

7. Vorrichtung nach einem der Ansprüche 4 bis 6,
**dadurch gekennzeichnet**,
daß segmentierte Richtlicht-Beleuchtung (RB1),
- Leuchtdioden (LD1) aufweist, die unter Ausschluß der Winkel segmente (WS) sektorenweise auf einem zur optischen Achse (OA) des Objektivs (O) koaxialen Kreis oder Polygon angeordnet sind,
und daß segmentierte Richtlicht-Beleuchtung (RB1), mit einem koaxial zur optischen Achse (OA) des Objektivs (O) angeordneten Ring- oder Polygon-Spiegel (SP) versehen ist, der die von den Leuchtdioden (LD1) emittierten Strahlen (S1) schräg auf die Oberfläche der Bauelemente (BE) lenkt.

8. Vorrichtung nach einem der Ansprüche 1 bis 7,
**gekennzeichnet durch** eine zweite, separat zu- und abschaltbare, segmentierte Ringlicht-Beleuchtung (RB2), deren Strahlen (S2) unter einem Beleuchtungswinkel (α2) von 15 bis 45° zur optischen Achse (OA) des Objektivs (O) auf die Oberfläche der Bauelemente einfallen.

9. Vorrichtung nach einem der Ansprüche 1 bis 7,
**gekennzeichnet durch** eine zweite, separat zu- und abschaltbare, segmentierte Ringlicht-Beleuchtung (RB2), deren Strahlen (S2) unter einem Beleuchtungswinkel (α2) von 25 bis 35° zur optischen Achse (OA) des Objektivs (O) auf die Oberfläche der Bauelemente einfallen.

10. Vorrichtung nach einem der Ansprüche 1 bis 7,
**gekennzeichnet durch** eine zweite, separat zu- und abschaltbare, segmentierte Ringlicht-Beleuchtung (RB2), deren Strahlen (S2) unter einem Beleuchtungswinkel (α2) von ungefähr 30° zur optischen Achse (OA) des Objektivs (O) auf die Oberfläche der Bauelemente einfallen.

11. Vorrichtung nach einem der Ansprüche 8 bis 10,
**dadurch gekennzeichnet**,
daß die zweite segmentierte Ringlicht-Beleuchtung (RB2) mit Leuchtdioden (LD2) versehen ist, die unter Ausschluß der Winkel segmente (WS) sektorenweise auf einem zur optischen Achse (OA) des Objektivs (O) koaxialen Kreis oder Polygon angeordnet sind.

## Claims

1. Apparatus for identifying the orientation of connections (A) on components (BE) which, on their connection side and in addition to the connections (A) have linear, optically disturbing surface structures (for example LBX, LBY) which run in two mutually perpendicular main directions (X, Y) parallel to the side edges of the component (BE),
in which case it is possible to position the components in the active region of the apparatus,
in which case the apparatus is provided with an image converter (BW) having an objective (O) and with at least one segmented annular light illuminating device (RB; RB1, RB2),
in which case the optical axis of the objective runs at least approximately through the centre of the annular light illuminating device,
in which case the objective (O) and the annular light illuminating device (RB; RB1, RB2) are arranged above the space provided for the components, and
in which case the component (BE) can be placed at least approximately centrally relative to the annular light illuminating device (RB; RB1, RB2), in an angular orientation in which the beams (S; S1, S2) of the annular light illuminating device (RB; RB1, RB2) are directed on all sides obliquely onto the surface of the components (BE), excluding angular segments (WS) which are located in the region of the main directions (X, Y).

2. Apparatus according to Claim 1, characterized in that the excluded angular segments (WS) of the annular light illuminating device (RB; RB1, RB2) are located in an angular range which differs from the main directions (X, Y) by - 15° to + 15°.

3. Apparatus according to Claim 1, characterized in that the excluded angular segments (WS) of the annular light illuminating device (RB1) are in an angular range which differs by approximately ± 10° from the main directions (X, Y).

4. Apparatus according to one of Claims 1 to 3, characterized in that the beams (S1) of the segmented annular light illuminating device (RB1) are directed onto the surface of the components (BE) at an illumination angle (α1) of 45 to 90° with respect to the optical axis (OA) of the objective (O).

5. Apparatus according to one of Claims 1 to 3, characterized in that the beams (S1) of the segmented annular light illuminating device (RB1) are directed onto the surface of the components (BE) at an illumination angle (α1) of 55 to 65° with respect to the optical axis (OA) of the objective (O).

6. Apparatus according to one of Claims 1 to 3, characterized in that the beams (S1) of the segmented annular light illuminating device (RB1) are directed onto the surface of the components (BE) at an illumination angle (α1) of approximately 60° with respect to the optical axis (OA) of the objective (O).

7. Apparatus according to one of Claims 4 to 6, characterized in that the segmented annular light illuminating device (RB1)
- has light-emitting diodes (LD1) which, excluding the angular segments (WS) are arranged sector-by-sector on a circle or polygon which is coaxial with respect to the optical axis (OA) of the objective (O),
and in that the segmented annular light illuminating device (RB1) is provided with an annular or polygonal mirror (SP) which is arranged coaxially with respect to the optical axis (OA) of the objective (O) and which deflects the beams (S1) emitted by the light-emitting diodes (LD1) obliquely onto the surface of the components (BE) .

8. Apparatus according to one of Claims 1 to 7, characterized by a second annular light illuminating device (RB2) which can be switched on and off separately and whose beams (S2) strike the surface of the components at an illumination angle (α2) of 15 to 45° with respect to the optical axis (OA) of the objective (O).

9. Apparatus according to one of Claims 1 to 7, characterized by a second annular light illuminating device (RB2) which can be switched on and off separately and whose beams (S2) strike the surface of the components at an illumination angle (α2) of 25 to 35° with respect to the optical axis (OA) of the objective (O).

10. Apparatus according to one of Claims 1 to 7, characterized by a second annular light illuminating device (RB2) which can be switched on and off separately and whose beams (S2) strike the surface of the components at an illumination angle (α2) of approximately 30° with respect to the optical axis (OA) of the objective (O).

11. Apparatus according to one of Claims 8 to 10, characterized in that the second segmented light illuminating device (RB2) is provided with light-emitting diodes (LD2) which, excluding the angular segments (WS), are arranged sector-by-sector on a circle or polygon which is coaxial with respect to the optical axis (OA) of the objective (O).

## Revendications

1. Dispositif de reconnaissance de la position des bornes (A) de composants (BE), qui sur leur côté de connexion présentent en plus des bornes (A) , des structures de surface (par exemple LBX, LBY) parasites sur le plan optique et de forme linéaire, qui s'étendent dans deux directions principales (X, Y) perpendiculaires l'une à l'autre, parallèlement aux bords latéraux du composant (BE), le dispositif présentant les particularités suivantes
les composants peuvent être placés dans la zone d'action du dispositif,
le dispositif est pourvu d'un convertisseur d'image (BW) comportant un objectif (O), et d'au moins une rampe d'éclairage annulaire (RB; RB1, RB2) segmentée,
l'axe optique de l'objectif passe au moins approximativement par le centre de la rampe d'éclairage annulaire,
l'objectif (O) et la rampe d'éclairage annulaire (RB, RB1, RB2) sont placés au-dessus de l'emplacement prévu pour les composants, et
le composant (BE) peut être placé par rapport à la rampe d'éclairage annulaire (RB; RB1, RB2) au moins approximativement de manière centrale, dans une position angulaire dans laquelle les rayons (S; S1, S2) de la rampe d'éclairage annulaire (RB; RB1, RB2) sont dirigés de toute part de manière oblique sur la surface des composants (BE), à l'exclusion des segments angulaires (WS) situés dans la zone des directions principales (X, Y).

2. Dispositif selon la revendication 1, caractérisé en ce que les segments angulaires (WS) exclus de la rampe d'éclairage annulaire (RB; RB1, RB2) se situent dans la plage angulaire s'écartant de - 15° à + 15° des directions principales (X, Y).

3. Dispositif selon la revendication 1, caractérisé en ce que les segments angulaires (WS) exclus de la rampe d'éclairage annulaire (RB; RB1, RB2) se situent dans la plage angulaire s'écartant d'environ ± 10° des directions principales (X, Y).

4. Dispositif selon l'une des revendications 1 à 3, caractérisé en ce que les rayons (S1) de la rampe d'éclairage annulaire (RB1) segmentée sont dirigés sur la surface des composants (BE) sous un angle d'éclairage (α1) de 45° à 90° par rapport à l'axe optique (OA) de l'objectif (O).

5. Dispositif selon l'une des revendications 1 à 3, caractérisé en ce que les rayons (S1) de la rampe d'éclairage annulaire (RB1) segmentée sont dirigés sur la surface des composants (BE) sous un angle d'éclairage (α1) de 55° à 65° par rapport à l'axe optique (OA) de l'objectif (O) .

6. Dispositif selon l'une des revendications 1 à 3, caractérisé en ce que les rayons (S1) de la rampe d'éclairage annulaire (RB1) segmentée sont dirigés sur la surface des composants (BE) sous un angle d'éclairage (α1) d'environ 60° par rapport à l'axe cptique (OA) de l'objectif (O).

7. Dispositif selon l'une des revendications 4 à 6, caractérisé en ce que la rampe d'éclairage annulaire (RB1) segmentée comprend des diodes électroluminescentes (LD1) qui sont disposées par secteurs, à l'exclusion des segments angulaires (WS), sur un cercle ou un polygone coaxial à l'axe optique (OA) de l'objectif (O),
et en ce que la rampe d'éclairage annulaire (RB1) segmentée est dotée d'un miroir (SP) annulaire ou polygonal, qui est disposé coaxialement à l'axe optique (OA) de l'objectif (O), et qui dévie obliquement les rayons (S1) émis par les diodes électroluminescentes (LD1) sur la surface des composants (BE).

8. Dispositif selon l'une des revendications 1 à 7, caractérisé par une seconde rampe d'éclairage annulaire (RB2) segmentée pouvant être mise en fonctionnement et arrêtée séparément, dont les rayons (S2) tombent sur la surface des composants sous un angle d'éclairage (α2) de 15 à 45° par rapport à l'axe optique (OA) de l'objectif (O).

9. Dispositif selon l'une des revendications 1 à 7, caractérisé par une seconde rampe d'éclairage annulaire (RB2) segmentée pouvant être mise en fonctionnement et arrêtée séparément, dont les rayons (S2) tombent sur la surface des composants sous un angle d'éclairage (α2) de 25 à 35° par rapport à l'axe optique (OA) de l'objectif (O).

10. Dispositif selon l'une des revendications 1 à 7, caractérisé par une seconde rampe d'éclairage annulaire (RB2) segmentée pouvant être mise en fonctionnement et arrêtée séparément, dont les rayons (S2) tombent sur la surface des composants sous un angle d'éclairage (α2) d'environ 30° par rapport à l'axe optique (OA) de l'objectif (O).

11. Dispositif selon l'une des revendications 8 à 10, caractérisé en ce que la seconde rampe d'éclairage annulaire (RB2) segmentée est dotée de diodes électroluminescentes (LD2) qui sont disposées par secteurs, à l'exclusion des segments angulaires (WS), sur un cercle ou un polygone coaxial à l'axe optique (OA) de l'objectif (O).
